# EUROPEAN PATENT APPLICATION

(11) **EP 1 361 192 A2**
(43) Date of publication of application: **12.11.2003**
(21) Application number: 03100793.3
(22) Date of filing: 27.03.2003
(51) Int. Cl.: B81C 1/00, B81B 7/00

(54) **METHODS OF METAL COATING CONTACT HOLES IN MEMS AND SIMILAR APPLICATIONS**

(30) Priority: 28.03.2002 GB 2073484
(71) Applicant: Zarlink Semiconductor Limited, Swindon, Wiltshire SN4 2QW (GB)
(72) Inventor: Martin, Brian, PL6 6LQ, Roborough, Plymouth (GB); Perring, John, PL9 7BL, Plymouth (GB); Shannon, John, PL7 1SJ, Plympton, Plymouth (GB)
(74) Representative: Asquith, Julian Peter

(57) **Abstract**

A method of coating contact holes in MEMS and micro-machining applications comprises:
providing an insulating layer above an integrated circuit;
providing a resist layer above the insulating layer;
patterning and developing the resist layer in order to form at least one contact aperture in the resist layer;
isotropically etching the insulating layer using the resist layer as a mask, so that a contact hole is formed in the insulating layer; and
coating the walls of said contact hole with a layer of metal.

## Description

The invention relates to methods of coating contact holes in MEMS and micro-machining applications, and to MEMs or micro-mechanical devices formed by such methods.

In MEMS and micromachining technologies connection of the MEMS device to the underlying IC is often achieved by defining a contact hole and depositing metal into the contact areas, and this process is often executed by sputtering the metal coating. Sputtering is a technique whereby metal is effectively deposited on areas visible on line-of-site from the metal target. When the coating is thin, of the order of 100nm, and the contact formed in a high aspect-ratio area, ie, one whose height is large compared to its width, eg greater than 2:1, it is difficult to coat completely the insides of the recess formed by the contact hole.

According to the invention there is provided a method of coating contact holes in MEMS and micro-machining applications, and a MEMs or micro-mechanical device formed by such a method, as set out in the accompanying claims.

Embodiments of the invention will now be more particularly described, with reference to the accompanying drawings, in which:
Figure 1 shows the first stage in a method of forming a contact hole in a MEMS device;
Figure 2 shows the second stage in the method, in which a contact aperture is etched in the resist layer;
Figure 3 shows the result of using an anisotropic etching process to form a contact hole in the insulating layer;
Figure 4 shows the result of using an isotropic etching process to form a contact hole in the insulating layer; and
Figure 5 shows the contact hole after coating with metal using a sputtering technique.

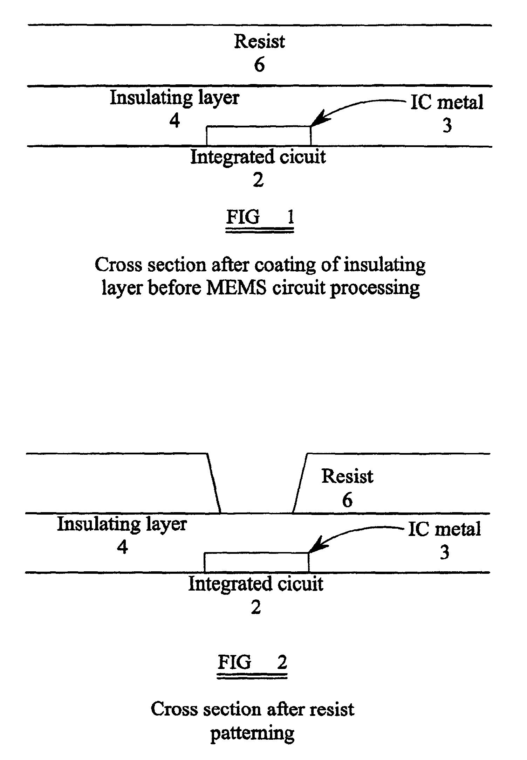

Figure 1 shows a cross section diagram of a completed IC (integrated circuit) 2, represented by its metal interconnect layer 3, coated with an organic material layer 4, whose thickness is dependent on the device application but is typically 2-3 microns but may be greater, and a resist layer 6 whose thickness is of the same order as the organic layer 4. Polyimide, for instance, has the requisite properties for the organic layer 4.

When the resist 6 is patterned, in the process of making contact to the IC metal 3, and developed the cross-sectional profile as is shown in Figure 2. A contact aperture 8 is formed in the resist 6. The slope of the resist wall angle is typically 80°.

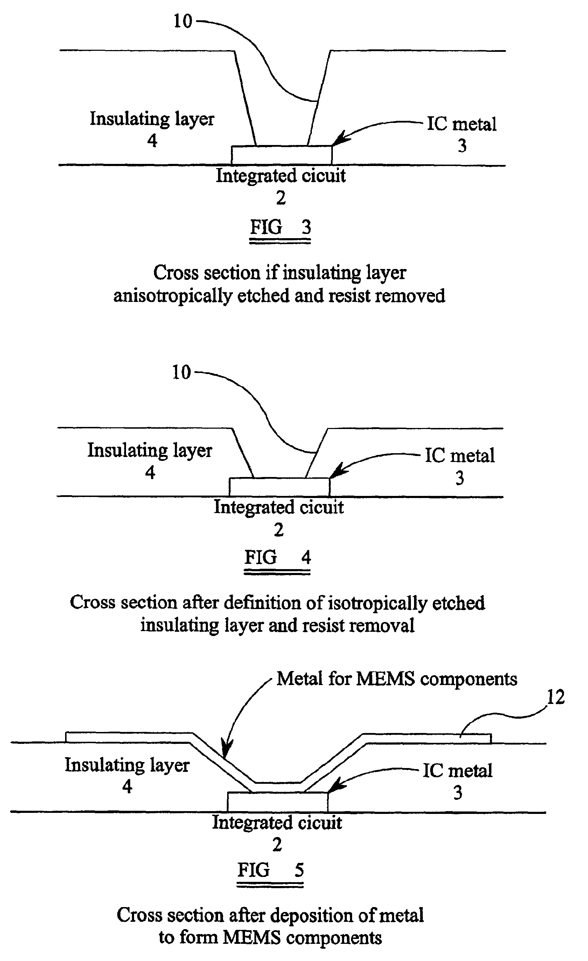

Next the insulating layer 4 is etched using the resist 6 as a mask to form a contact hole 10 and the resist 6 removed. If the etching process is anisotropic (no sideways etching component) the resulting profile in the organic layer 4 after resist removal has the same angle as the contact aperture 8 of the resist, as shown in Figure 3.

Conversely if the organic material 4 is isotropically etched then the resulting profile of contact hole 10 exhibits a much less steep wall angle, as shown in Figure 4, when the selectivity of the organic layer 4 to the resist mask 6 is low.

The shallow wall angle of Figure 4 allows a sputtering technique to be used to apply a thin metal coating12, as shown in Figure 5, whereas the steeper profile of Figure 4 does not allow successful sputtering.

The process described thus uses an organic layer, whose thickness defines the contact hole depth, which, after patterning by lithography and then etching, enables sputtered metal to completely cover the base and sides of the contact hole. The organic layer must be isotropically etched with low selectivity to the resist mask. Isotropic etching is when the lateral rate of etching equals the rate of the vertical component. After processing, the organic layer can be removed or left in-situ depending on the application. The process is useful in cases where the MEMS component is separated from the integrated circuit (IC) by a distance of 2-3 microns or greater but has to be connected to it.

Preferably, the organic layer is isotropically etched with a selectivity of about 1:1 to the resist mask, and the ratio of vertical etch rate to lateral etch rate is between 1:1 and 3:1.

## Claims

1. A method of coating contact holes in MEMS and micro-machining applications, the method comprising:
providing an insulating layer above an integrated circuit;
providing a resist layer above the insulating layer;
patterning and developing the resist layer in order to form at least one contact aperture in the resist layer;
isotropically etching the insulating layer using the resist layer as a mask, so that a contact hole is formed in the insulating layer; and
coating the walls of said contact hole with a layer of metal.

2. A method as claimed in claim 1, wherein the insulating layer is an organic layer.

3. A method as claimed in claim 2, wherein the organic layer is formed of polyimide.

4. A method as claimed in any preceding claim, wherein said layer of metal has a thickness of about 100nm.

5. A method as claimed in any preceding claim, wherein the insulating layer is etched with low selectivity to the resist mask, so that the walls of said contact hole are inclined at a shallow angle.

6. A method as claimed in any preceding claim, wherein the walls of said contact aperture in the resist layer are inclined at an angle of about 80 degrees to the plane of the resist layer.

7. A method as claimed in any preceding claim, wherein said resist layer is patterned by photo-lithography.

8. A method as claimed in any preceding claim, wherein the insulating layer is isotropically etched with a selectivity of 1:1.

9. A method as claimed in any preceding claim, wherein the ratio of vertical etch rate to lateral etch rate is between 1:1 and 3:1.

10. A MEMs or micro-mechanical device comprising at least one contact hole formed in accordance with the method of any preceding claim.
